# EUROPEAN PATENT SPECIFICATION

(11) **EP 1 371 755 B1**
(45) Date of publication and mention of the grant of the patent: **28.02.2007**
(21) Application number: 02716431.8
(22) Date of filing: 29.01.2002
(51) Int. Cl.: C23C 18/31, H01L 21/768, H01L 21/288, C23C 18/16

(54) **METHOD OF ELECTROLESS PLATING AND APPARATUS FOR ELECTROLESS PLATING**
VERFAHREN ZUR STROMLOSEN METALLABSCHEIDUNG UND VORRICHTUNG ZUR STROMLOSEN METALLABSCHEIDUNG
PROCEDE ET APPAREIL DE DEPOT AUTOCATALYTIQUE

(30) Priority: 07.02.2001 JP 2001030824
(43) Date of publication of application: 17.12.2003
(73) Proprietor: TOKYO ELECTRON LIMITED, Minato-ku, Tokyo 107-8481 (JP)
(72) Inventor: SATO, Hiroshi c/o TOKYO ELECTRON LIMITED, Nirasaki-shi, Yamanashi 407-0192 (JP)
(74) Representative: Liesegang, Eva
(86) International application number: PCT/JP2002/000623
(87) International publication number: WO 2002/063067

(56) References cited:
- EP-A- 0 770 705
- JP-A- 8 319 578
- JP-A- 10 280 157
- JP-A- 11 140 657
- JP-A- 2000 133 619
- JP-B1- 49 036 541

## Description

### Technical Field

The present invention relates to a plating method and an apparatus for plating, more particularly to an electroless plating method and an apparatus for electroless plating for plating objects to be treated such as semiconductor wafers and LCD substrates.

### Background Art

In recent years, copper has been used as metal wiring in semiconductor devices. Plating is one of film-forming methods in which copper is buried in the surface of a semiconductor wafer having minute trenches and holes in order to form this copper wiring.

Plating includes electrolytic plating and electroless plating. In accordance with the increase in wafer diameter and the further miniaturization of the minute trenches and holes, the electroless plating has been drawing attention.

In conventional electroless plating, a plating solution including additives such as a reducing agent, a pH regulator and a chelating agent, and metallic salt has been used.

In the conventional electroless plating, however, the additives and the metallic salt were mixed in the plating solution used for the treatment. When such a plating solution is used, the deposition rate and a buried shape are greatly dependent on the additives in the plating solution, and nonuniformity in the buried shape lowers operation reliability of semiconductor devices. Therefore, it has been necessary to strictly regulate the composition of the additives in the plating solution, pH of the plating solution, and the temperature. Further, a large quantity of the plating solution has been consumed in the conventional electroless plating due to a low deposition rate. Moreover, the plating solution adheres to a front face and a rear face of the wafer after the plating, and this plating solution has been a cause of contamination.

### Disclosure of the Invention

The present invention is made in consideration of the problems stated above, and an object thereof is to provide an electroless plating method and an apparatus for electroless plating with high practicability that enable washing of the front and rear faces of a wafer after the wafer is plated.

In order to solve the problems stated above, an electroless plating method according to an aspect of the present invention is characterized in that it includes: a metal ion solution supply step of supplying a solution containing metal ions to a front face of an object to be treated; a first wash supply step of supplying a first wash to the front face of the object to be treated; a second wash supply step of supplying a second wash to a peripheral edge of the object to be treated; and a third wash supply step of supplying a third wash to a rear face of the object to be treated. With the electroless plating method according to the aspect of the present invention, it is possible to wash the front and rear faces of the object to be treated immediately after the plating of the object to be treated is finished, so that throughput can be improved.

In the above-mentioned electroless plating method, the metal ion solution supply step may be performed while the object to be treated is being rotated. The supply of the solution containing the metal ions while the object to be treated is being rotated makes it possible to uniformly supply the solution containing the metal ions to the object to be treated. Further, it can reduce a supply amount of the solution containing the metal ions, resulting in reduction in a consumption amount of the plating solution.

In the above-mentioned electroless plating method, the metal ion solution supply step may be performed while the object to be treated is being vibrated. The supply of the solution containing the metal ions while the object to be treated is being vibrated enables quick infusion of the solution containing the metal ions into minute holes and trenches of the object to be treated.

In the above-mentioned electroless plating method, the metal ion solution supply step may be performed while liquid or gas is being supplied to a rear face of the object to be treated. The supply of the solution containing the metal ions while the liquid or the gas is being supplied from the rear face of the object to be treated makes it possible to prevent the deposition on the rear face of the object to be treated.

In the above-mentioned electroless plating method, the solution containing the metal ions may be either one of a copper sulfate solution and a copper hydrochloride solution. The use of either one of the copper sulfate solution and the copper hydrochloride solution makes it possible to form a copper plating film on the front face of the object to be treated.

It is preferable that the above-mentioned electroless plating method further includes an additive supply step of supplying an additive to the front face of the object to be treated. The additive and the solution containing the metal ions are separated, so that the composition of a plating solution can be easily regulated.

In the above-mentioned electroless plating method, the additive preferably includes a reducing agent. The inclusion of the reducing agent in the additive makes it possible to easily cause the reduction reaction of the metal ions.

In the above-mentioned electroless plating method, the additive supply step may be performed while the object to be treated is being rotated. The supply of the additive while the object to be treated is being rotated enables uniform supply of the additive to the object to be treated. Further, it can reduce an amount of the supplied additive, resulting in reduction in a consumption amount of the plating solution.

In the above-mentioned electroless plating method, the additive supply step may be performed while the object to be treated is being vibrated. The supply of the additive while the object to be treated is vibrated enables quick infusion of the additive into minute holes and trenches of the object to be treated.

In the above-mentioned electroless plating method, the additive supply step may be performed while liquid or gas is being supplied to a rear face of the object to be treated. The supply of the additive while the liquid or the gas is being supplied from the rear face of the object to be treated makes it possible to prevent the deposition on the rear face of the object to be treated.

An apparatus for electroless plating according to another aspect of the present invention is characterized in that it includes: a holding mechanism to hold an object to be treated; a metal ion solution supply system to supply a solution containing metal ions to a front face of the object to be treated; a first wash supply system to supply a first wash to the front face of the object to be treated; a second wash supply system to supply a second wash to a peripheral edge of the object to be treated; and a third wash supply system to supply a third wash to a rear face of the object to be treated. With the apparatus for electroless plating according to the aspect of the present invention, the front and rear faces of the object to be treated can be washed immediately after the plating of the object to be treated is finished, so that throughput can be improved.

It is preferable that the above-mentioned apparatus for electroless plating further includes an additive supply system to supply an additive to the front face of the object to be treated. By providing the additive supply system, the additive and the solution containing the metal ions can be separated, so that the composition of the plating solution can be easily regulated.

The above-mentioned apparatus for electroless plating can further include a flow-around preventive mechanism to prevent liquid from flowing around to the rear face of the object to be treated. By providing the flow-around preventive mechnism, the deposition on the rear face of the object to be treated can be prevented.

The above-mentioned apparatus for electroless plating can further include a rotating mechanism to rotate the object to be treated. By providing the rotating mechanism, the additive or the solution containing metal can be uniformly supplied to the object to be treated. Further, it can reduce a supply amount of the additive or the solution containing the metal, resulting in reduction in a consumption amount of the plating solution.

The above-mentioned apparatus for electroless plating can further include a vibrating mechanism to vibrate the object to be treated. By providing the vibrating mechanism, the additive or the solution containing the metal can be infused quickly into minute holes and trenches of the object to be treated.

### Brief Description of Drawings

FIG. 1 is a schematic side view showing the whole structure of an electroless plating system including an apparatus for electroless plating according to an embodiment.
FIG. 2 is a schematic plane view showing the whole structure of the electroless plating system including the apparatus for electroless plating according to the embodiment.
FIG. 3 is a cross sectional view of the apparatus for electroless plating according to the embodiment.
FIG. 4 is a top view of a rear face washing nozzle according to the embodiment.
FIG. 5 is an enlarged vertical sectional view taken along the V-V line in FIG. 4.
FIG. 6 is a cutaway side view and front view showing a part of an essential portion of a holding member according to the embodiment.
FIG. 7 is a view showing a method of washing a peripheral edge of a wafer according to the embodiment.
FIG. 8 is a flowchart of plating according to the embodiment.
FIG. 9A, FIG. 9B, FIG. 9C, FIG. 9D, and FIG. 9E are schematic views of the plating according to the embodiment.

### Best Mode for Implementing the Invention

An apparatus for electroless plating according to an embodiment of the present invention will be explained below with reference to the drawings.

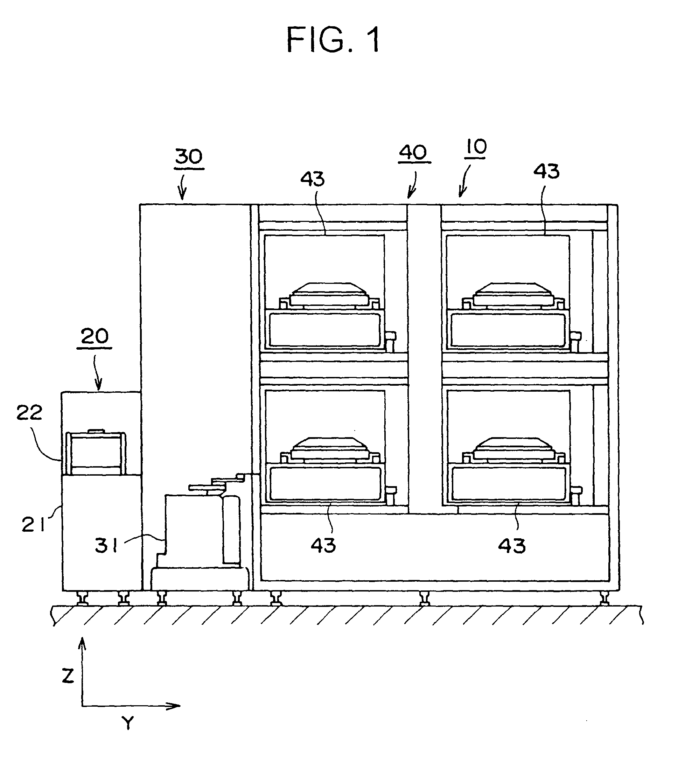

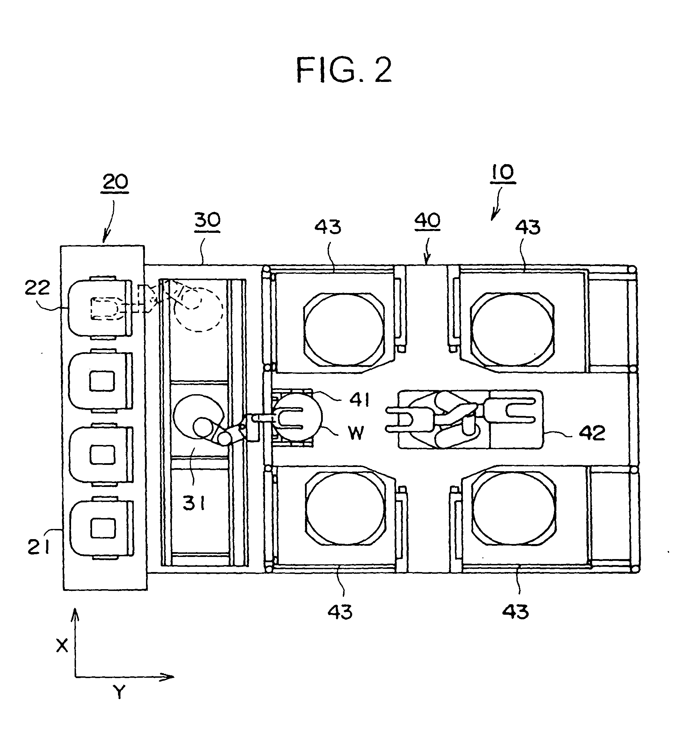

FIG. 1 and FIG. 2 are views showing the whole structure of an electroless plating system according to this embodiment, FIG. 1 being a side view thereof and FIG. 2 being a plane view thereof.

As shown in FIG. 1, a plating system 10 is composed of a cassette station 20, a transfer section 30, and a process station 40.

The cassette station 20 has a cassette mounting table 21 disposed therein, and a cassette 22 housing wafers W as objects to be treated is mounted on the cassette mounting table 21. Note that a plated wafer W is carried out, being housed in the transfer cassette 22.

The transfer section 30 has a first transfer mechanism 31, which transfers the wafer W housed in the cassette 22 to the process station 40. Further, the first transfer mechanism 31 transfers the plated wafer W from the process station 40 to the cassette 22.

Note that the cassette station 20 and the transfer section 30 are kept in a purified atmosphere by downflow of a purified air supplied from an external part.

The process station 40 has a mounting section 41 disposed therein for temporarily mounting the plural wafers W on a transfer section 30 side. A second transfer mechanism 42 is disposed in a center portion of the process station 40, and apparatuses for electroless plating 43 are arranged around the second transfer mechanism 42.

The mounting section 43 is so structured to mount the plural wafers W in multiple tiers so that the wafer W before being plated and the wafer W after being plated are not placed at the same position.

The process station 40 is vertically divided into two tiers. On an upper tier and a lower tier, the plural apparatuses for electroless plating 43 are disposed respectively, for example, totally eight are disposed, four on the upper tier and four on the lower tier.

The wafer W is transferred inside the process station 40 by the second transfer mechanism 42. The second transfer mechanism 42 receives the wafer W that is placed on the mounting section 41 by the first transfer mechanism 31 and carries the wafer W to either one of the apparatuses for electroless plating 43. The second transfer mechanism 42 also takes out the wafer W that has been plated from the apparatus for electroless plating 43 to place the wafer W on the mounting section 41.

The second transfer mechanism 42 is structured to be rotatable around the Z axis shown in FIG. 1 and to be ascendable/descendible in the Z direction so that it is capable of accessing each of the apparatuses for electroless plating 43 in the process station 40 which has the two-tiered structure described above.

Further, the second transfer mechanism 42 has two carrier arms. One of them is used for the transfer from the mounting section 41 to the apparatuses for electroless plating 43 and the other one is used for the transfer from the apparatuses for electroless plating 43 to the mounting section 41. This can minimize the contamination of the wafer W that has been plated.

In this embodiment, eight apparatuses for electroless plating 43 are provided, but the number thereof can be increased as required. Further, treatment apparatuses different from the apparatuses for electroless plating 43, for example, annealing apparatuses that perform annealing can be provided.

Hereinafter, the apparatus for electroless plating 43 will be explained.

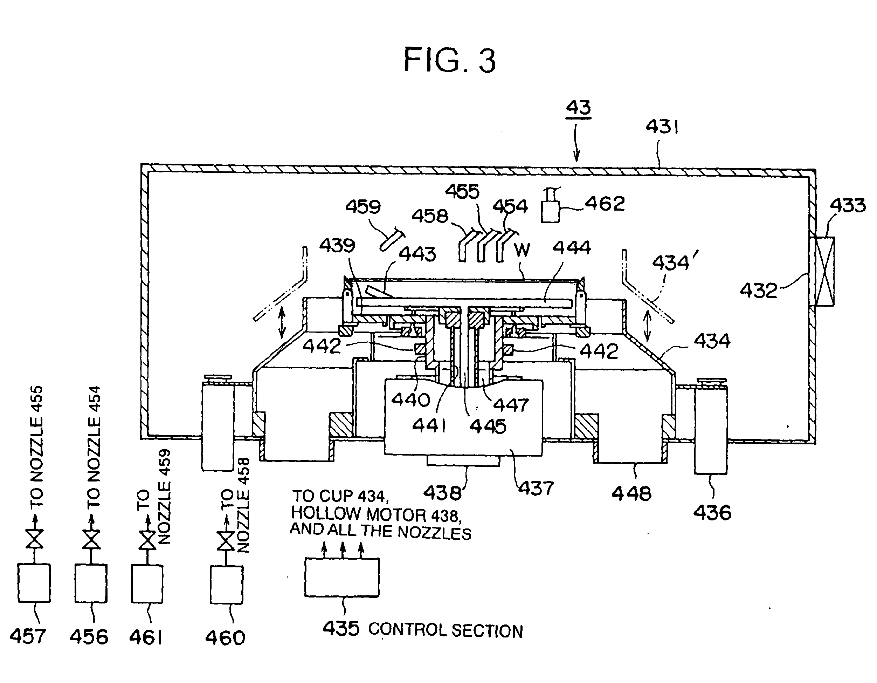

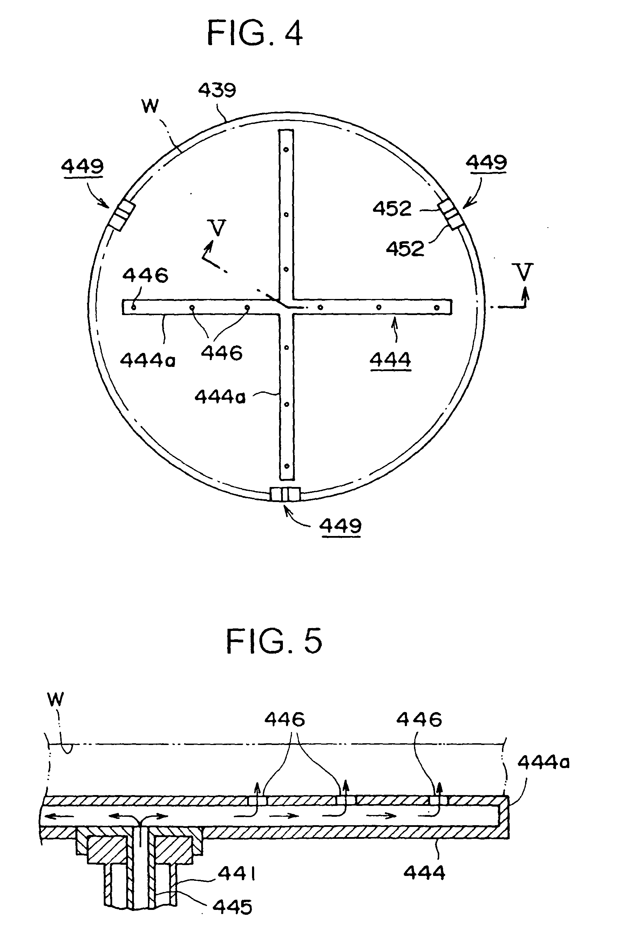

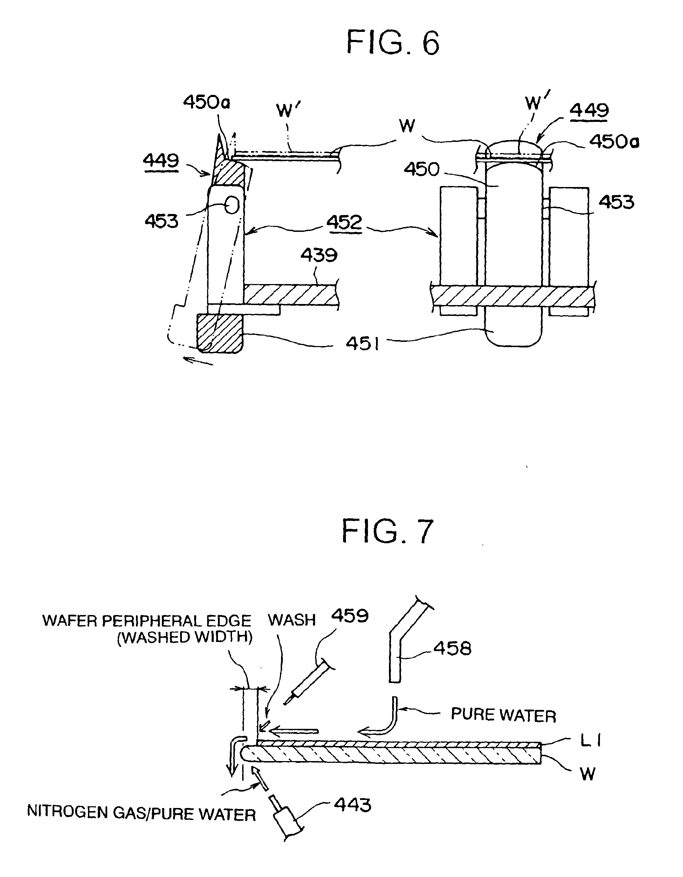

FIG. 3 is a cross sectional view of the apparatus for electroless plating according to this embodiment, and FIG. 4 is a top view of a rear face washing nozzle according to this embodiment. FIG. 5 is an enlarged vertical sectional view taken along the V-V line in FIG. 4, and FIG. 6 is a cutaway side and front view showing a part of an essential portion of a holding member according to this embodiment.

As shown in FIG. 3 to FIG. 6, the apparatus for electroless plating 43 has a square housing 431. A gateway 432 for the second transfer mechanism 42 is formed in the housing 431, and a gate valve 433 is provided at the gateway 432.

A substantially cylindrical cup 434 having an open upper face is disposed in the housing 431. The cup 434 is vertically ascended/descended by a cup driving section 436 controlled by a control section 435.

The control section 435, which is constituted of a ROM and so on storing an arithmetic operation, processing programs, and so on, is connected to the cup 434, a hollow motor 437, all the nozzles, and so on and controls the operation of the entire apparatus for electroless plating 43. The explanation on the operation of the control section 435 will be omitted in order to make the whole explanation easily understandable.

A rotary driver 438 is disposed in a center position of the housing 431. The rotary driver 438 is rotated at a predetermined rotation speed by the drive of the hollow motor 437 disposed outside the housing 431. A rotary table 439 is fixed above the rotary driver 438 with a predetermined interval provided therebetween. A second shaft 441 is formed inside a first shaft 440 of the rotary driver 438. The first shaft 440 has a vibrating mechanism 442 attached thereto.

A flow-around control nozzle 443 supported by an appropriate supporting means is disposed in the second shaft 441. The flow-around control nozzle 443 is pointed toward a peripheral edge of the rear face of the wafer W at an acute angle, and emits an inert gas such as a nitrogen gas or a pure water from a tip thereof. This prevents the electroless plating solution from flowing around to the rear face during the treatment.

Further, a rear face washing nozzle 444 to supply a wash to the rear face of the wafer W is fixed on the second shaft 441. The rear face washing nozzle 444 is disposed so as to be between the wafer W and the rotary table 439 when the wafer W is held by the holding member.

The rear face washing nozzle 444 is so structured that four stick members 444a extend to the peripheral edge of the rotary table 439 in a cross shape whose center is a portion at which the rear face washing nozzle 444 is fixed to the second shaft 441. The inside of the stick members 444a is hollow and communicates with a pipe 445 passing through the inside of the second shaft 441. The wash flows through the pipe 445 to be supplied upward to the wafer W from opening holes 446 that are formed in upper portions of the stick members 409a of the rear face washing nozzle 409.

A gas passage 447 is formed in a space between the first shaft 440 and the second shaft 441, so that an inert gas, for example, a nitrogen gas is blown out from here.

Exhaust ports 448 are formed in a lower portion of the cup 434. The inert gas blown out from the gas passage 447 flows along the surface of the rotary table 439 toward the peripheral edge of the rotary table 439. Thereafter, it is exhausted from the peripheral edge of the rotary table 439, in other words, the peripheral edge of the wafer W to the exhaust ports 448. This can prevent the contamination of the rear face of the wafer W.

Three holding members 449 are attached to the peripheral edge of the rotary table 439 at equal intervals of the angle 120° .

Each of the holding members 449 is constituted of an upper holding portion 450 and a lower bias portion 451 integrated together. The holding portion 450 has a step 450a formed at an upper end thereof for holding the wafer W thereon. The holding portion 450 is pivotally attached to a supporting member 452 for supporting the holding member 449. Specifically, the holding member 449 is attached to a pivotal shaft 453 formed at an upper end of the supporting member 452, and pivots on the pivotal shaft 453. The weight of the bias portion 451 is set to be larger than that of the holding portion 450, so that the bias portion 451 works as a weight of the holding member 449.

Since the wafer W is rotated at a high speed by the rotary driver 438, it is necessary to hold the wafer W stably. For this purpose, the holding member 449 is structured not only to hold the wafer W by the step 450a of the holding portion 450 but also to hold the peripheral edge of the wafer W by a biased force given by the bias portion 451.

Specifically, the wafer W is placed on and held by the holding member 449 while it is not rotating. Then, when the rotary table 439 rotates, the bias portion 451 moves in an outward direction as shown by the arrow in FIG. 6 due to a centrifugal force. As a result, the holding portion 450 of the holding member 449 is pressed toward the center side of the rotary table 439, so that the wafer W is firmly held at a position W'. Further, the holding portion 450 of the holding member 449 is formed in a convex shape (curved shape) when seen from the front side thereof as shown in FIG. 6 and holds the wafer W by point contact such as three-point support utilizing the step 450a of the holding portion 450.

An additive supply nozzle 454 to supply additives for electroless plating and a metal ion solution supply nozzle 455 to supply a solution containing metal ions are disposed above the rotary table 439.

The additive supply nozzle 454, which is connected to an additive supply source 456, supplies the additives stored in the additive supply source 456 from a tip thereof. The additive supply nozzle 454 is so structured that the tip thereof moves to the center of the wafer W when the wafer W is placed on the rotary table 439.

The additive supply source 456 stores the additives therein. The additives include a reducing agent, a pH regulator, a surfactant, a chelating agent, and other substances necessary for reduction reaction. Here, the reducing agent is a substance contributing to the reaction of reducing the metal ions such as formaldehyde, for example, reducing Cu²⁺ to Cu. Incidentally, the additives may be stored separately.

The metal ion solution supply nozzle 455, which is connected to a metal ion solution supply source 457, supplies the solution containing the metal ions stored in the metal ion solution supply source 457 from a tip thereof. The metal ion solution supply nozzle 455 is so structured that the tip thereof moves to the center of the wafer W when the wafer W is placed on the rotary table 439.

The metal ion solution supply source 457 stores therein, for example, a copper sulfate solution. The copper sulfate solution may contain chlorine when necessary. Further, the metal ion solution may be a copper hydrochloride solution other than the copper sulfate solution. Thus, the copper sulfate solution is stored without any additive mixed therein, which enables stable control of the composition of the copper sulfate solution.

Further, a main washing nozzle 458 and an edge washing nozzle 459 that perform washing after the plating are disposed above the rotary table 439. The main washing nozzle 458, which is connected to a first wash tank 460, supplies from a tip thereof a treatment solution stored in the first wash tank 460 at a predetermined supply rate. The main washing nozzle 458 is so structured that the tip thereof moves to the center of the wafer W when the wafer W is placed on the rotary table 439.

The edge washing nozzle 459, which is connected to a second wash tank 461, supplies from a tip thereof a wash stored in the second wash tank 461 at a predetermined supply rate. Here, the wash stored in the second wash tank 461 is a solution in which acid chemical such as inorganic acid such as hydrofluoric acid, hydrochloric acid, or sulfuric acid, or organic acid, is mixed with hydrogen peroxide, for example, a mixed solution of hydrofluoric acid and hydrogen peroxide. In this embodiment, the mixed solution whose composition is hydrofluoric acid : hydrogen peroxide : water = 1:1:23 is used.

A film thickness measuring sensor 462 to measure the thickness of a plating film formed on the wafer W is disposed above the cup 434.

FIG. 7 is a view showing a method of washing the peripheral edge of the wafer W according to this embodiment. As shown in FIG. 7, a copper layer L1 is formed on the front face of the wafer W by electroless plating. The edge washing nozzle 459 supplies the wash to the peripheral edge of the wafer W to wash the peripheral edge of the wafer W (etching) while a pure water is being supplied to the front face of the wafer W from the main washing nozzle 458.

An essential portion of the apparatus for electroless plating 43 according to this embodiment is structured as described above. The treatment operation thereof will be explained below with reference to FIG. 1, FIG. 2, and FIG. 3.

As shown in FIG. 1 to FIG. 3, the wafer W is first taken out from the cassette 22 to be placed on the mounting section 41 by the first transfer mechanism 31. The wafer W placed on the mounting section 41 is transferred through the gateway 432 of the housing 431 into the apparatus for electroless plating 43 by the second transfer mechanism 42, and placed on the holding members 449 (refer to FIG. 6) disposed in the peripheral edge of the rotary table 439. Thereafter, the second transfer mechanism 42 retreats through the gateway 432 to the outside of the housing 431. At this time, the cup 434 is at the lowest position of the descent. After the second transfer mechanism 42 retreats, the treatment is started.

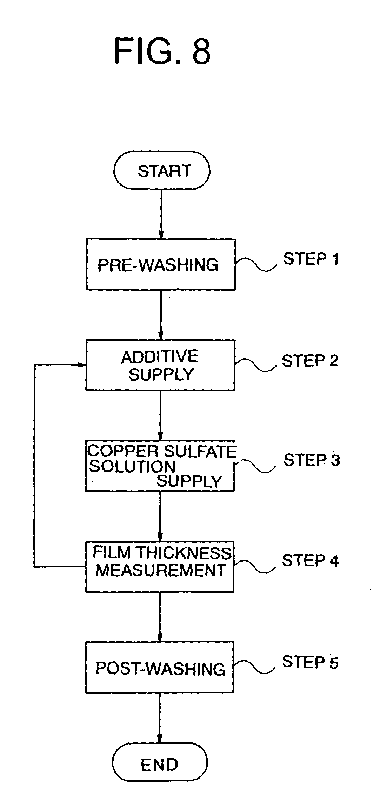

An electroless plating method of this embodiment will be explained with reference to the treatment flow shown in FIG. 8. First, pre-washing for removing organic matter and particles adhering to the front face of the wafer W and for improving wettability of the wafer W is carried out (Step 1).

Next, the additive is supplied to the front face of the wafer W (Step 2). Subsequently, the copper sulfate solution is supplied to the front face of the wafer W (Step 3). The film thickness of the copper layer L1 formed by the electroless plating is measured (Step 4). Step 2 to Step 4 are repeated until a predetermined film thickness is obtained, to form a film on the wafer W. When the predetermined film thickness is obtained, the electroless plating is finished, and post-washing is conducted (Step 5). The wafer W is subjected to the electroless plating through the treatment flow described above.

The treatment sequence of the electroless plating method and the apparatus for electroless plating of the present invention will be explained below.

The hollow motor 437 rotates the rotary driver 438, thereby rotating the rotary table 439 and also rotating the wafer W held by the holding member 449. At this time, the cup 434 is ascended to the highest position 434' by the cup driving section 436 to prevent the treatment solution and so on from scattering inside the housing 341.

Next, after the rotation speed of the rotary table 439 reaches a predetermined rotation speed, a nitrogen gas or a pure water is emitted from the flow-around control nozzle 443 to the peripheral edge of the rear face of the wafer W. Thereafter, predetermined treatment solutions mentioned below are supplied to the wafer W in sequence to start the treatment.

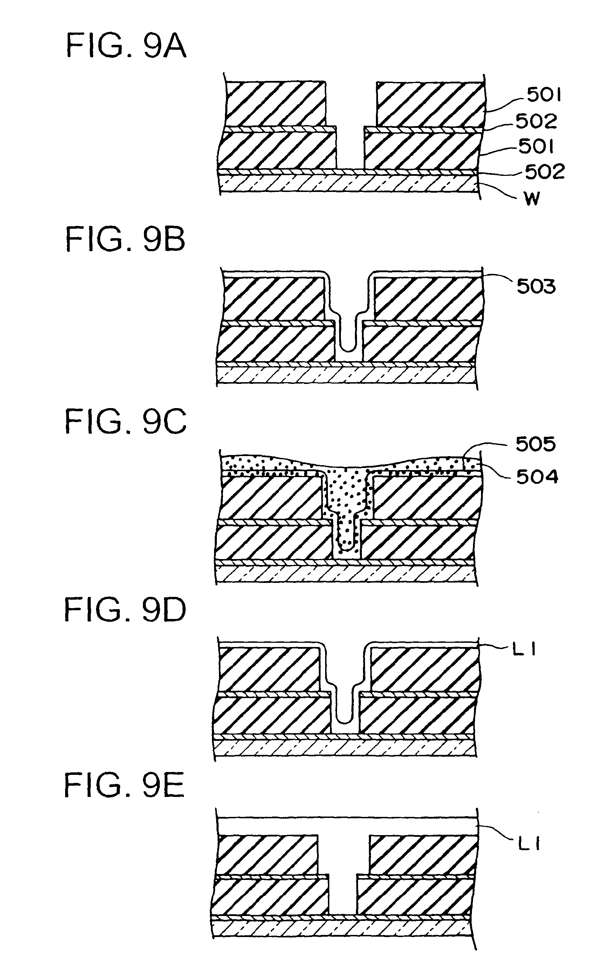

Hereinafter, copper film formation using the electroless plating method of the embodiment will be explained with reference to FIG. 9A, FIG. 9B, FIG. 9C, FIG. 9D, and FIG. 9E which are schematic views of the dual damascene structure in which minute holes and trenches are formed in an insulation film 501 and a SiN film 502.

In the pre-washing, a predetermined pre-treatment solution is supplied to the front face of the wafer W from the main washing nozzle 454. This removes the organic matter and particles adhering to the front face of the wafer W and also improves wettability (FIG. 9A).

Next, an additive 503 is supplied to the front face of the wafer W from the additive supply nozzle 458. Through this process, the additive 503 is uniformly applied onto the front face of the wafer W (FIG. 9B). Incidentally, the vibrating mechanism 442 is driven at this time to give vibration to the wafer W if necessary. Giving the vibration to the wafer W makes it possible to infuse the additive deep into the minute holes and trenches.

Subsequently, the solution containing the metal ions, which is a copper sulfate solution 504 here, is supplied to the front face of the wafer W from the metal ion solution supply nozzle 459 (FIG. 9C). Incidentally, the vibrating mechanism 442 is driven at this time to give vibration to the wafer W if necessary. Giving the vibration to the wafer W makes it possible to infuse the copper sulfate solution deep into the minute holes and trenches.

By the supply of the copper sulfate solution 504, the reduction reaction between copper ions 505 included in the copper sulfate solution 504 and the reducing agent included in the additive 503 is caused on the front face of the wafer W, so that the copper layer L1 is formed (Fig. 9D).

The thickness of the formed copper layer L1 is measured by the film thickness measuring sensor 462. The supply of the additive 503 and the supply of the copper sulfate solution 504 are repeated until the measured copper layer L1 has a predetermined value, thereby forming the copper layer L1 (FIG. 9E). Then, the reducing agent in the additive 503 and the copper ions are supplied continuously to cause the reduction reaction of copper on the front face of the wafer W.

When the copper layer L1 has the predetermined film thickness, the post-washing is started. In this post-washing, a pure water is first supplied to the front face of the wafer W from the main washing nozzle 454. Next, while the pure water is being supplied by the main washing nozzle 454, the wash is supplied to the peripheral edge of the wafer W from the edge washing nozzle 455. Subsequently, the wash is supplied to the rear face of the wafer W from the rear face washing nozzle 443.

After the front face, the peripheral edge, and the rear face of the wafer W are washed, the wafer W is washed by a pure water. The pure water is supplied to both of the faces of the wafer W from the main washing nozzle 454 above the front face of the wafer W and from the rear face washing nozzle 443 below the rear face of the wafer W.

After the washing by the pure water, the wafer W is spin-dried. In this spin-drying, the rotation speed of the rotary table 439 is increased up to a predetermined rotation speed (2000 rpm to 3000 rpm), and at the same time, the nitrogen gas is supplied from the main washing nozzle 454 above the wafer W and from the rear face washing nozzle 443 below the rear face of the wafer W, thereby drying the wafer W for a predetermined period of time. At this time, the cup 434 is at a descended position (the solid line portion in FIG. 3) so as not to obstruct the transfer of the wafer W by the second transfer mechanism 42.

After the above-described treatment, the wafer W is carried out of the apparatus for electroless plating 43 through the gateway 432 of the housing 431 by the second transfer mechanism 42.

### Industrial Applicability

An electroless plating method and an apparatus for electroless plating according to the present invention are usable in the semiconductor manufacturing industry.

## Claims

1. An electroless plating method of forming a plating film on a front face of an object to be treated, comprising:
a metal ion solution supply step of supplying a solution containing metal ions to the front face of the object to be treated;
a first wash supply step of supplying a first wash to the front face of the object to be treated;
a second wash supply step of supplying a second wash to a peripheral edge of the object to be treated; and
a third wash supply step of supplying a third wash to a rear face of the object to be treated.

2. An apparatus for electroless plating that forms a plating film on a front face of an object to be treated, comprising:
a holding mechanism to hold the object to be treated;
a metal ion solution supply system to supply a solution containing metal ions to the front face of the object to be treated;
a first wash supply system to supply.a first wash to the front face of the object to be treated;
a second wash supply system to supply a second wash to a peripheral edge of the object to be treated; and
a third wash supply system to supply a third wash to a rear face of the object to be treated.

3. An electroless plating method as set forth in claim 1, wherein said metal ion solution supply step is performed while the object to be treated is being rotated.

4. An electroless plating method as set forth in claim 1, wherein said metal ion solution supply step is performed while the object to be treated is being vibrated.

5. An electroless plating method as set forth in claim 1, wherein said metal ion solution supply step is performed while liquid or gas is being supplied to a rear face of the object to be treated.

6. An electroless plating method as set forth in claim 1, wherein the solution containing the metal ions is either one of a copper sulfate solution and a copper hydrochloride solution.

7. An electroless plating method as set forth in claim 1, further comprising an additive supply step of supplying an additive to the front face of the object to be treated.

8. An electroless plating method as set forth in claim 7, wherein the additive includes a reducing agent.

9. An electroless plating method as set forth in claim 7, wherein said additive supply step is performed while the object to be treated is being rotated.

10. An electroless plating method as set forth in claim 7, wherein said additive supply step is performed while the object to be treated is being vibrated.

11. An electroless plating method as set forth in claim 7, wherein said additive supply step is performed while liquid or gas is being supplied to the rear face of the object to be treated.

12. An apparatus for electroless plating as set forth in claim 2, further comprising an additive supply system to supply an additive to the front face of the object to be treated.

13. An apparatus for electroless plating as set forth in claim 2, further comprising a flow-around preventive mechanism to prevent liquid from flowing around to the rear face of the object to be treated.

14. An apparatus for electroless plating as set forth in claim 2, further comprising a rotating mechanism to rotate the object to be treated.

15. An apparatus for electroless plating as set forth in claim 2, further comprising a vibrating mechanism to vibrate the object to be treated.

## Patentansprüche

1. Stromfreies Plattierungsverfahren zum Bilden eines Plattierungsfilmes auf einer Vorderseite eines zu behandelnden Objektes, welches die folgenden Schritte umfaßt:
eine Metallionenlösung-Zufuhrschritt, in dem eine Lösung, welche Metallionen enthält, der Vorderseite des zu behandelnden Objekts zugeführt wird;
einen ersten Waschmitttelzufuhrschritt, in dem der Vorderseite des zu behandelnden Objekts ein erstes Waschmittel zugeführt wird;
einen zweiten Waschmittelzufuhrschritt, in dem einem Umfangsrand des zu behandelnden Objektes ein zweites Waschmittel zugeführt wird; und
einen dritten Waschmittelzufuhrschritt, in dem einer Rückseite des zu behandelnden Objektes ein drittes Waschmittel zugeführt wird.

2. Vorrichtung für eine stromfreie Plattierung, die einen Plattierungsfilm auf einer Vorderseite eines zu behandelnden Objekts ausbildet, umfassend:
eine Haltevorrichtung zum Halten des zu behandelnden Objekts;
ein Metallionenlösung-Zufuhrsystem zum Zuführen einer Lösung, welche Metallionen enthält, zu der Vorderseite des zu behandelnden Objekts;
ein erstes Waschmittelzufuhrsystem zum Zuführen eines ersten Waschmittels zur Vorderseite des zu behandelnden Objekts;
ein zweites Waschmittelzufuhrsystem zum Zuführen eines zweiten Waschmittels zu einem Umfangsrand des zu behandelnden Objekts; und
ein drittes Waschmittelzufuhrsystem zum Zuführen eines dritten Waschmittels zu einer Rückseite des zu behandelnden Objekts.

3. Stromfreies Plattierungsverfahren nach Anspruch 1, in dem der Metallionenlösung-Zufuhrschrittt durchgeführt wird, während das zu behandelnde Objekt gedreht wird.

4. Stromfreies Plattierungsverfahren nach Anspruch 1, bei dem der Metallionenlösung-Zufuhrschritt durchgeführt wird, während das zu behandelnde Objekt in Vibration versetzt wird.

5. Stromfreies Plattierungsverfahren nach Anspruch 1, bei dem der Metallionenlösung-Zufuhrschritt durchgeführt wird, während eine Flüssigkeit oder ein Gas zur Rückseite des zu behandelnden Objekts zugeführt wird.

6. Stromfreies Plattierungsverfahren nach Anspruch 1, bei dem die Lösung, die die Metallionen enthält, entweder eine Kupfersulfatlösung oder eine Kupferhydrochloridlösung ist.

7. Stromfreies Plattierungsverfahren nach Anspruch 1, welches ferner einen Additiv-Zufuhrschritt umfaßt, in dem der Vorderseite des zu behandelnden Objekts ein Additiv zugeführt wird.

8. Stromfreies Plattierungsverfahren nach Anspruch 7, bei dem das Additiv ein Reduktionsmittel enthält.

9. Stromfreies Plattierungsverfahren nach Anspruch 7, bei dem der Additiv-Zufuhrschritt durchgeführt wird, während das zu behandelnde Objekt gedreht wird.

10. Stromfreies Plattierungsverfahren nach Anspruch 7, bei dem der Additiv-Zufuhrschritt durchgeführt wird, während das zu behandelnde Objekt in Vibration versetzt wird.

11. Stromfreies Plattierungsverfahren nach Anspruch 7, bei dem der Additiv-Zufuhrschritt durchgeführt wird, während der Rückseite des zu behandelnden Objekts eine Flüssigkeit oder ein Gas zugeführt wird.

12. Vorrichtung zur stromfreien Plattierung nach Anspruch 2, die ferner ein Additiv-Zufuhrsystem umfaßt, um der Vorderseite des zu behandelnden Objekts ein Additiv zuzuführen.

13. Vorrichtung zur stromfreien Plattierung nach Anspruch 2, die ferner eine Herumfließ-Verhinderungseinrichtung umfaßt, um zu verhindern, daß eine Flüssigkeit zu der Rückseite des zu behandelnden Objekts herumfließt.

14. Vorrichtung zur stromfreien Plattierung nach Anspruch 2, die ferner eine Dreheinrichtung zum Drehen des zu behandelnden Objekts umfaßt.

15. Vorrichtung zur stromfreien Plattierung nach Anspruch 2, die ferner eine Vibrationseinrichtung zum Versetzen des zu behandelnden Objektes in Vibration umfaßt.

## Revendications

1. Procédé de dépôt autocatalytique pour former une couche de revêtement sur la face avant d'un objet à traiter comprenant :
une étape de fourniture d'une solution métallique ionique pour fournir une solution contenant des ions métalliques sur la face avant de l'objet à traiter ;
une première étape de fourniture de lavage pour fournir un premier lavage de la face avant de l'objet à traiter ;
une seconde étape de fourniture de lavage pour fournir un second lavage du bord périphérique de l'objet à traiter; et
une troisième étape de fourniture de lavage pour fournir un troisième lavage de la face arrière de l'objet à traiter.

2. Dispositif de dépôt autocatalytique pour former une couche de revêtement sur la face avant d'un objet à traiter comprenant :
un mécanisme support pour porter l'objet à traiter ;
un système de fourniture d'une solution métallique ionique pour fournir une solution contenant des ions métalliques sur la face avant de l'objet à traiter ;
un premier système de fourniture de lavage pour fournir un premier lavage de la face avant de l'objet à traiter;
un second système de fourniture de lavage pour fournir un second lavage du bord périphérique de l'objet à traiter ; et
un troisième système de fourniture de lavage pour fournir un troisième lavage de la face arrière de l'objet à traiter.

3. Procédé de dépôt autocatalytique selon la revendication 1, dans lequel l'étape de fourniture d'une solution métallique ionique est réalisée tandis que l'objet à traiter est en rotation.

4. Procédé de dépôt autocatalytique selon la revendication 1, dans lequel l'étape de fourniture d'une solution métallique ionique est réalisée tandis que l'objet à traiter est en vibration.

5. Procédé de dépôt autocatalytique selon la revendication 1, dans lequel l'étape de fourniture d'une solution métallique ionique est réalisée tandis qu'un liquide ou un gaz est fourni vers la face arrière de l'objet à traiter.

6. Procédé de dépôt autocatalytique selon la revendication 1, dans lequel la solution contenant les ions métalliques est une solution de sulfate de cuivre ou une solution d'hydrochlorure de cuivre.

7. Procédé de dépôt autocatalytique selon la revendication 1, comprenant en outre une étape de fourniture supplémentaire d'un additif vers la face avant de l'objet à traiter.

8. Procédé de dépôt autocatalytique selon la revendication 7, dans lequel l'additif inclut un agent réducteur.

9. Procédé de dépôt autocatalytique selon la revendication 7, dans lequel l'étape de fourniture de l'additif est réalisée tandis que l'objet à traiter est en vibration.

10. Procédé de dépôt autocatalytique selon la revendication 7, dans lequel l'étape de fourniture de l'additif est réalisée tandis que l'objet à traiter est en vibration.

11. Procédé de dépôt autocatalytique selon la revendication 7, dans lequel l'étape de fourniture de l'additif est réalisée tandis qu'un liquide ou un gaz est fourni vers la face arrière de l'objet à traiter.

12. Dispositif de dépôt autocatalytique selon la revendication 2, comprenant en outre un système de fourniture d'additif pour fournir un additif vers la face avant de l'objet à traiter.

13. Dispositif de dépôt autocatalytique selon la revendication 2, comprenant en outre un mécanisme pour empêcher une circulation périphérique pour empêcher un liquide de circuler autour de la face arrière de l'objet à traiter.

14. Dispositif de dépôt autocatalytique selon la revendication 2, comprenant en outre un mécanisme de rotation pour mettre en rotation l'objet à traiter.

15. Dispositif de dépôt autocatalytique selon la revendication 2, comprenant en outre un mécanisme de vibration pour mettre en vibration l'objet à traiter.
